# EUROPEAN PATENT APPLICATION

(11) **EP 2 139 108 A1**
(43) Date of publication of application: **30.12.2009**
(21) Application number: 08158911.1
(22) Date of filing: 24.06.2008
(51) Int. Cl.: H03F 3/19, H03F 3/217, H04B 10/12, H03F 3/08

(54) **A method for signal amplification using a power amplifier system, a power ampifier system, a base station, a mobile station and a communication network therefor**

(71) Applicant: Alcatel-Lucent Deutschland AG, 70435 Stuttgart (DE)
(72) Inventor: Fischer, Georg, 90425, Nuremberg (DE)
(74) Representative: Urlichs, Stefan

(57) **Abstract**

The invention concerns a method for signal amplification using a power amplifier system comprising at least two amplifying transistors (T1, T2), whereby at least one optical connection from a driver (DR) of at least one of said at least two amplifying transistors (T1, T2) to at least one processing means with photosensitive material is used to control the gate (G) or the base of said at least one of said at least two amplifying transistors (T1, T2), a power amplifier system, a base station, a mobile station and a communication network therefor.

## Description

The invention relates to a power amplifier system according to the preamble of claim 1, a base station according to the preamble of claim 10, a mobile station according to the preamble of claim 11, a communication network according to the preamble of claim 12, and a method for signal amplification using a power amplifier system according to the preamble of claim 13.

Mobile communication systems like e.g. Universal Mobile Telecommunications System (UMTS), Third Generation Partnership Project Long Term Evolution (3GPP LTE) or Worldwide Interoperability for Microwave Access (WIMAX) require power amplifiers with high output power at frequencies up to 3.8 GHz.

In the communication industry, there is always a pressure to reduce costs, especially Operational Expenditures (OPEX) and equipment costs (Capital Expenditures CAPEX), to be competitive. Therefore the industry is permanently searching for possibilities to reduce the cost for operation of equipment and of the goods sold. One means to reduce the costs for operation is to increase the power efficiency of the analogue hardware by changing the RF power amplifier architecture.

As an alternative to the currently used linear operation mode of e.g. class-A/AB amplifiers, a new architecture may use so-called switch mode amplifiers, as e.g. class-D/E/F or class-S amplifiers, to improve the power efficiency. The class-S approach inherently leads to higher efficiency of the power amplifier of theoretically 100% and by means of the digital approach reduces analogue imperfections and liability to distortions.

Switch mode amplifiers, as e.g. class S amplifiers, are a preferred architecture, as digital power amplifiers fit the general direction of the architecture for software defined radio (SDR) and thus higher level of digitization of the transceiver, and as the switch mode amplifier architecture is the only architecture offering a 100% theoretical efficiency limit. A Class-AB amplifier architecture for instance can never have an efficiency better than 78% due to fundamental physical limitations. It is above all in the operator's interest to get as close as possible to the theoretical efficiency limit.

In said switch mode radio frequency (RF) power amplifiers, the transistor is not amplifying the input signal linearly, but is acting as a switch in the ideal case. As an ideal switch does not dissipate power, a theoretical power efficiency of 100% could be reachable.

Switch mode power amplifiers can either be realized in a current switched or in a voltage switched mode. In the Master of Science Thesis from Anthony Lawrence Long, Department of Electrical and Computer Engineering, University of California, Santa Barbara, CA 93106-9560 from May 2003, the basic principle of current switched mode class D power amplifier architecture is disclosed.

When driving the transistors of the final stage of a switch mode power amplifier, it is important that the driving signal keeps a perfect rectangular shape in order to keep efficiency up.

However the gate of the switching transistors typically has high input capacitance making it difficult to maintain a good rectangular shape. Smoothing of the rectangular shape by the R-C circuit consisting of the driver's output impedance combined with the input capacitance of the switching transistor may easily lead to a loss of efficiency by 10 to 20%. Simulations have revealed that a 50 Ohm source impedance by the driver is too high, instead a driver with 1 Ohm output impedance is needed.

Furthermore there is the second problem that the gate drive signal is always referenced to the source of the transistor. Now with a voltage switched circuit topology, the source of one transistor is floating, which makes it difficult to drive it. The driver circuit would have to provide a very large voltage swing which is difficult to obtain especially with a rectangular signal and a large gate capacitance.

The object of the invention is thus to provide a power amplifier system offering driving signals of the transistors that have a rectangular shape and allow source potential of the transistors to float.

This object is achieved by a power amplifier system according to the teaching of claim 1, a base station according to the teaching of claim 10, a mobile station according to the teaching of claim 11, a communication network according to the teaching of claim 12, and a method for signal amplification using a power amplifier system according to the teaching of claim 13.

The main idea of the invention is to no longer use a direct electrical drive of the gate of the transistor, i.e. to no longer use a direct electrical connection from the driver to the gate, but to use light for signal transmission from the driver, so that there is e.g. an optical fiber connected from the driver either to the transistor or to a photo detector that is in turn connected to the transistor. In principle, it is proposed to use an optical connection from the driver of the transistor to a processing means with photosensitive material in order to control the gate of the transistor.

Further developments of the invention can be gathered from the dependent claims and the following description.

In the following the invention will be explained further making reference to the attached drawings.

Fig. 1 schematically shows a switched mode power amplifier architecture relying on a voltage switched circuit topology according to the state-of-the-art.

Fig. 2 schematically shows a switched mode power amplifier architecture relying on a current switched circuit topology according to the state-of-the-art.

Fig. 3 schematically shows a switched mode power amplifier architecture relying on a voltage switched circuit topology using an optical drive and photo detectors according to the invention.

Fig. 4 schematically shows a switched mode power amplifier architecture relying on a voltage switched circuit topology using an optical drive and phototransistors according to the invention.

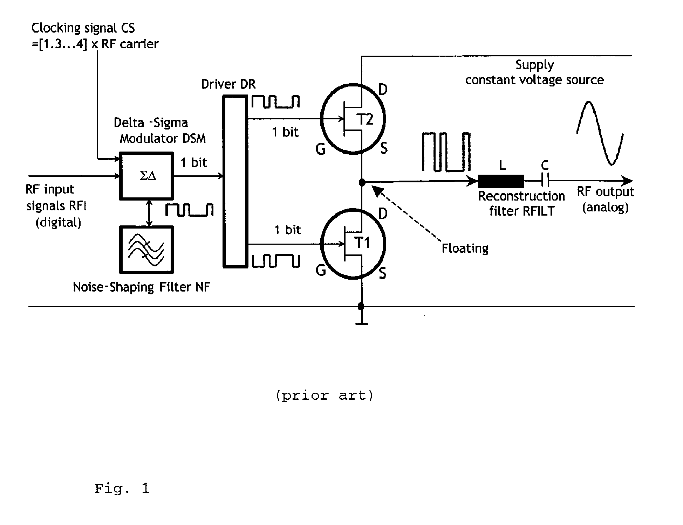

A voltage switched power amplifier system according to the state-of-the-art as shown in fig. 1 comprises a delta-sigma modulator DSM with inputs for reception of a digital or analogue RF input signal RFI and for reception of a clocking signal CS. An output of the delta-sigma modulator DSM is connected to an input of a driver DR.

Preferably, the delta-sigma modulator DSM is connected to a noise-shaping filter NF.

A first output of the driver DR is connected to the gate G of a first transistor T1, and a second output of the driver DR is connected to the gate G of a second transistor T2.

The source S of the first transistor T1 is connected to ground, and the source of the second transistor T2 is connected to the drain of the first transistor T1.

The drain of the first transistor T1 and the source of the second transistor T2 are connected to an RF output via a reconstruction filter RFILT that comprises an inductor L and a capacitor C in series. There are variants of the L-C filter topology which however are of no importance for the invention as disclosed.

The drain of the second transistor T2 is connected to the supply of a constant voltage source.

In a method for signal amplification using a voltage switched power amplifier system according to the state-of-the-art as shown in fig. 1, digital or analogue RF input signals are sent to the delta-sigma modulator DSM. Furthermore, clocking signals with a multiple of the RF carrier frequency are sent to the delta-sigma modulator DSM.

In the delta-sigma modulator DSM, the digital or analogue RF input signals are converted into digital 1-bit or higher resolution signals using a so-called sample-and-hold output. The sampling rate is determined by the received clocking signals. The digital 1-bit or multibit signals are provided at the output of the delta-sigma modulator DSM.

Preferably, the noise shaping filter NF is used to minimize quantization error by means of shifting quantization noise into frequency ranges that are less or not relevant for signal processing.

Said digital 1-bit signals are sent to the driver DR that generates first driver signals based on the digital 1-bit signals and second driver signals based on the inverted digital 1-bit signals. The first driver signals are sent to the gate of the second transistor T2, and the second driver signals are sent to the gate of the first transistor T1. The output signals of the driver DR are thus in antiphase which means if the first transistor T1 is on, the second transistor T2 is off and vice versa. The described amplifier architecture with two transistors T1, T2 is just an example, and in alternative architectures, more than two transistors are used, which has however no influence on the invention. Such alternative architectures are e.g. multibit architectures, using two transistors more per each bit more.

The gate driving signal for transistor T2 is referenced to the source of T2. As the source of T2 is connected to the RF output, this source potential is floating. For transistor T1 the source potential is connected to ground, i.e. it is static.

For GaN transistors the gate-source voltage for "on"-state is typically +1 V and for "off"-state -5 V. Assuming a +48 V supply voltage, the gate driving signal for transistor T1 is between -5 V and +1 V. In contrast to this for transistor T2 the gate driving signal is between -5 V for "off" and +49 V for "on". There is a clear asymmetry in driving the two gates of transistor T1 and transistor T2. For transistor T1 the peak-to-peak voltage swing is 6 V, and for transistor T2, the peak-to-peak voltage swing is 54 V. This asymmetry is problematic as it causes signal distortions.

The capacitor C and the inductor L together build a reconstruction filter RFILT used to generate smooth analogue output signals that are provided at the RF output.

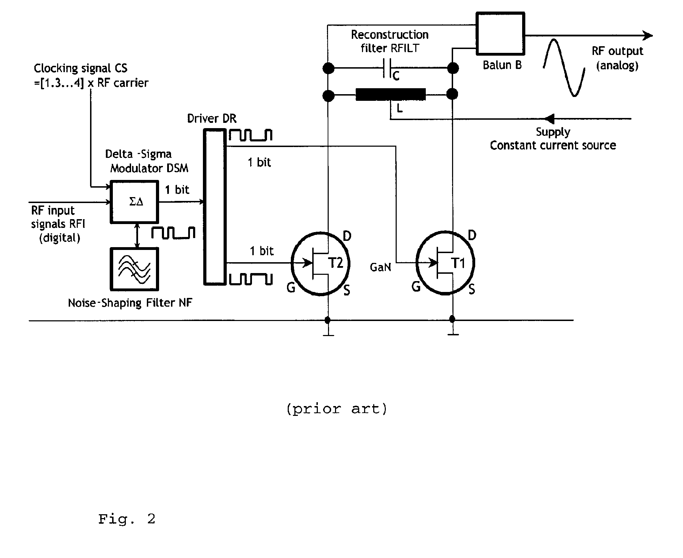

Fig. 2 shows as a second alternative a switched power amplifier system realized in a current switched mode.

A current switched power amplifier system according to the state-of-the-art as shown in fig. 2 comprises a delta-sigma modulator DSM with inputs for reception of a digital or analogue RF input signal RFI and for reception of a clocking signal CS. An output of the delta-sigma modulator DSM is connected to an input of a driver DR.

Preferably, the delta-sigma modulator DSM is connected to a noise-shaping filter NF.

A first output of the driver DR is connected to the gate of a first transistor T1, and a second output of the driver DR is connected to the gate of a second transistor T2.

Both the source of the first transistor T1 and the source of the second transistor T2 are connected to ground.

The drain of the first transistor T1 is connected to a first input of an inductor L and to a first input of a capacitor C, and the drain of the second transistor T2 is connected to a second input of the inductor L and to a second input of the capacitor C. The capacitor C and the inductor L build together a reconstruction filter RFILT. There are variants of the L-C filter topology which however are of no importance for the invention as disclosed.

The supply of a constant current source is connected to a third input of the inductor L.

Furthermore, the drain of the first transistor T1 is connected to a first input of a balun B, and the drain of the second transistor T2 is connected to a second input of the balun B. The balun B transforms a balanced input signal to a single ended signal. At the balun's output the analogue RF output signal is provided.

In a method for signal amplification using a current switched power amplifier system according to the state-of-the-art as shown in fig. 2, digital or analogue RF input signals are sent to the delta-sigma modulator DSM. Furthermore, clocking signals with a multiple of the RF carrier frequency are sent to the delta-sigma modulator DSM.

In the delta-sigma modulator DSM, the digital or analogue RF input signals are converted into digital 1-bit or higher resolution signals using a so-called sample-and-hold output. The sampling rate is determined by the received clocking signals. The digital 1-bit or multibit signals are provided at the output of the delta-sigma modulator DSM.

Preferably, the noise shaping filter NF is used to minimize quantization error by means of shifting quantization noise into frequency ranges that are less or not relevant for signal processing.

Said digital 1-bit signals are sent to the driver DR that generates first driver signals based on the digital 1-bit signals and second driver signals based on the inverted digital 1-bit signals. The first driver signals are sent to the gate of the first transistor T1, and the second driver signals are sent to the gate of the second transistor T2. The output signals of the driver DR are thus in antiphase which means if the first transistor T1 is on, the second transistor T2 is off and vice versa. The described amplifier architecture with two transistors T1, T2 is just an example, and in alternative architectures, more than two transistors are used, which has however no influence on the invention. Such alternative architectures are e.g. multibit architectures, using two transistors more per each bit more.

In the first transistor T1 and in the second transistor T2, the first driver signal and the second driver signal respectively are amplified resulting in a first and a second amplifier signal.

The capacitor C and the inductor L together build a reconstruction filter RFILT used to generate smooth analogue signals out of the first and the second amplifier signals.

The smoothed first and second analogue signals are sent to the balun B, in which the smoothed first and second analogue signals are added together, thus removing any noise that has been picked up along the way. In other words, the balun B converts balanced signals to unbalanced signals. The unbalanced RF output signals are provided at the output of the balun B.

Power amplifier systems in current switched circuit topology overcome the above mentioned problems of a floating source potential of transistor T2, as with the current switched circuit topology both transistors' sources are connected to ground. The driver DR is now symmetric and the peak-to-peak gate voltage swing is identical for both transistors T1 and T2.

However, the current switched topology does not solve the problem of driving a large gate capacitance. The challenge to provide a good rectangular signal in driving the gates G remains.

Furthermore, the current switched circuit topology needs a balun to transform its balanced output to the typically used single ended lines, which makes the current switched circuit topology more complex and more expensive than the voltage switched circuit topology.

The basic idea of the invention is, that the power amplifier system comprises at least one optical connection from the driver DR of at least one of said at least two amplifying transistors T1, T2 to at least one processing means with photosensitive material in order to control the gate G of said at least one of said at least two amplifying transistors T1, T2.

In a first embodiment, photo detectors comprising said photosensitive material are connected to the gates G. This embodiment overcomes the problem with the floating gate G of transistor T2 with the voltage switched circuit topology and ensures symmetry of the two driving paths.

In a second embodiment, light is used directly to activate the gates G of the transistors T1 and T2. In this embodiment, optical fibers are used as optical connections which end above the transistors T1 and T2. Specific transistors T1 and T2 with a fiber connector at their housing are needed in this embodiment. With such a configuration, the gate metallization in the transistors T1 and T2 could be removed, whereby the additional problem of large gate capacitances would no longer exist.

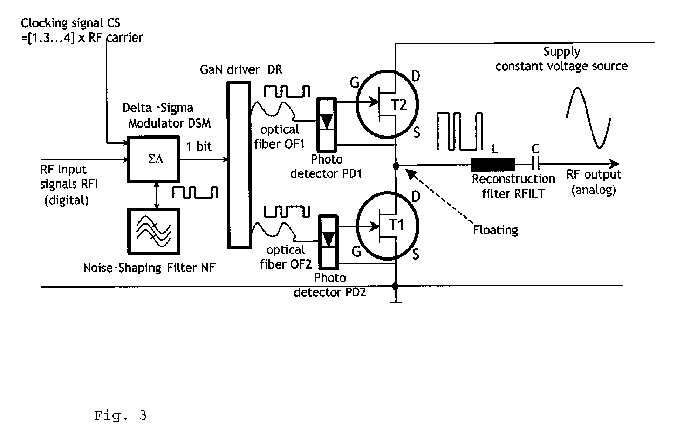

Fig. 3 shows a switched mode power amplifier architecture relying on a voltage switched circuit topology using an optical drive and photo detectors according to the first embodiment of the invention.

The voltage switched power amplifier system of fig. 3 corresponds to the voltage switched power amplifier system according to the state-of-the-art as shown in fig. 1 with the only difference being the connection between the driver DR and the two transistors T1 and T2.

In fig. 3, a first output of a driver DR is connected by means of an optical fiber OF1 to the input of a first photo detector PD1, and a second output of the driver DR is connected to the input of a second photo detector PD2.

A first output of the second photo detector PD2 is connected to the gate G of a first transistor T1, and a second output of the second photo detector PD2 is connected to the source S of the first transistor T1.

A first output of the first photo detector PD1 is connected to the gate G of a second transistor T2, and a second output of the first photo detector PD1 is connected to the source S of the second transistor T2.

In another embodiment, the second output of the second photo detector PD2 is connected to the drain D of the first transistor T1, and the second output of the first photo detector PD1 is connected to the drain D of the second transistor T2.

Preferably, the driver DR or the transistors T1 and T2 are fabricated in Gallium Nitride (GaN) technology.

The output signals sent from the driver DR are thus optical signals that are sent to the photosensitive material comprised in the photo detectors PD1 and PD2. The optical signals create a photo voltage in the photo detectors PD1 and PD2 between the two outputs which is used to drive the gates G.

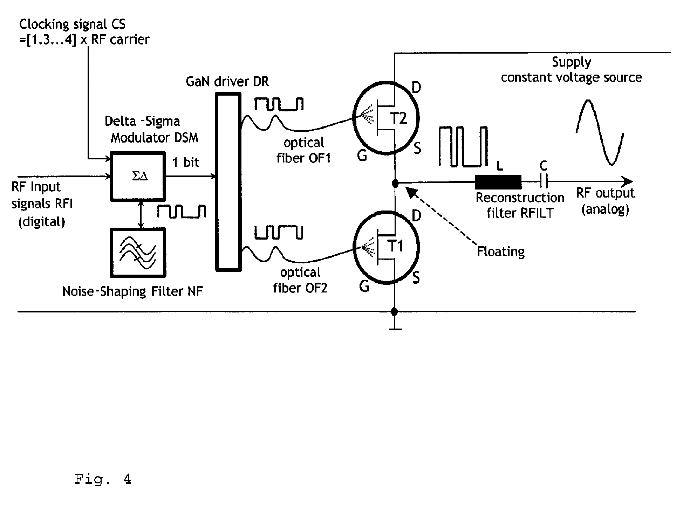

Fig. 4 shows a switched mode power amplifier architecture relying on a voltage switched circuit topology using an optical drive and phototransistors according to the second embodiment of the invention.

The voltage switched power amplifier system of fig. 4 corresponds to the voltage switched power amplifier system according to the state-of-the-art as shown in fig. 1 with the only difference being the connection between the driver DR and the two transistors T1 and T2.

In fig. 4, a first output of a driver DR is connected by means of an optical fiber OF2 to a fiber connector of a first phototransistor T1, and a second output of the driver DR is connected to a fiber connector of a second phototransistor T2, i.e. the optical fibers OF1 and OF2 end near to the transistors T1 and T2. In this embodiment, the transistors T1 and T2 have no gate connectors.

Preferably, the driver DR or the transistors T1 and T2 are fabricated in Gallium Nitride (GaN) technology.

The output signals sent from the driver DR are thus optical signals that are sent to the photosensitive material comprised in the phototransistors T1 and T2. The optical signals create a photo voltage in the phototransistors T1 and T2 which are thus directly activated.

Although the invention is described in the second embodiment above for a voltage switched power amplifier system, the optical driver as described can also be used in an analogue way for a current switched power amplifier system as described in fig. 2, as the optical driver provides equal benefits in overcoming the problem of a large gate capacitance for a current switched power amplifier system.

In the two embodiments above, alternatively a separate driver can be used for each transistor T1 and T2 instead of the common driver DR. Also, instead of optical fibers OF1 and OF2, alternatively optical free space connections between the driver DR and the photosensitive material can be used.

In the two embodiments above, the invention is described for transistors T1, T2 that comprise gate G, source S and drain D, as e.g. field effect transistors (FET). Alternatively, also bipolar transistors T1, T2 that comprise base, emitter and collector can be used for the invention instead.

Such a power amplifier system according to the invention as described above can be comprised in a transmitter used for transmission in a base station or a mobile station that are part of a communication network.

## Claims

1. A power amplifier system comprising at least two amplifying transistors (T1, T2), **characterized in, that** the power amplifier system comprises at least one optical connection from a driver (DR) of at least one of said at least two amplifying transistors (T1, T2) to at least one processing means with photosensitive material in order to control the gate (G) or the base of said at least one of said at least two amplifying transistors (T1, T2).

2. A power amplifier system according to claim 1, **characterized in, that** said at least one processing means with photosensitive material is a photo detector (PD1, PD2) that is connected to the gate (G) or the base and the source (S) or the emitter of said at least one of said at least two amplifying transistors (T1, T2).

3. A power amplifier system according to claim 1, **characterized in, that** said at least one processing means with photosensitive material is a photo detector (PD1, PD2) that is connected to the gate (G) or the base and the drain (D) or the collector of said at least one of said at least two amplifying transistors (T1, T2).

4. A power amplifier system according to claim 2 or 3, **characterized in, that** said photo detector (PD1, PD2) is a photodiode.

5. A power amplifier system according to claim 1, **characterized in, that** said at least one of said at least two amplifying transistors (T1, T2) is a phototransistor, and said at least one processing means with photosensitive material is integrated in the phototransistor.

6. A power amplifier system according to claim 5, **characterized in, that** an optical fiber (OF1, OF2) is connected from the driver (DR) to the gate (G) or the base of the phototransistor.

7. A power amplifier system according to claim 2 or 3, **characterized in, that** an optical fiber (OF1, OF2) is connected from the driver (DR) to the photo detector (PD1, PD2).

8. A power amplifier system according to claim 1, **characterized in, that**
• a first output of the driver (DR) is connected to the gate (G) or the base of a first transistor (T1) of said at least two amplifying transistors (T1, T2),
• a second output of the driver (DR) is connected to the gate (G) or the base of a second transistor (T2) of said at least two amplifying transistors (T1, T2),
• and the drain (D) or collector of the first transistor (T1) is connected to the source (S) or emitter of the second transistor (T2).

9. A power amplifier system according to claim 1, **characterized in, that**
• a first output of a driver (DR) is connected to the gate (G) or the base of a first transistor (T1) of said at least two amplifying transistors (T1, T2),
• a second output of a driver (DR) is connected to the gate (G) or the base of a second transistor (T2) of said at least two amplifying transistors (T1, T2),
• and the sources (S) or the emitters of both the first transistor (T1) and the second transistor (T2) are connected to ground.

10. A base station comprising at least one power amplifier system comprising at least two amplifying transistors (T1, T2), **characterized in, that** the power amplifier system comprises at least one optical connection from a driver (DR) of at least one of said at least two amplifying transistors (T1, T2) to at least one processing means with photosensitive material in order to control the gate (G) or the base of said at least one of said at least two amplifying transistors (T1, T2).

11. A mobile station comprising at least one power amplifier system comprising at least two amplifying transistors (T1, T2), **characterized in, that** the power amplifier system comprises at least one optical connection from a driver (DR) of at least one of said at least two amplifying transistors (T1, T2) to at least one processing means with photosensitive material in order to control the gate (G) or the base of said at least one of said at least two amplifying transistors (T1, T2).

12. A communication network with at least one base station or mobile station comprising at least one power amplifier system comprising at least two amplifying transistors (T1, T2), **characterized in, that** the power amplifier system comprises at least one optical connection from a driver (DR) of at least one of said at least two amplifying transistors (T1, T2) to at least one processing means with photosensitive material in order to control the gate (G) or the base of said at least one of said at least two amplifying transistors (T1, T2).

13. A method for signal amplification using a power amplifier system comprising at least two amplifying transistors (T1, T2), **characterized in, that** at least one optical connection from a driver (DR) of at least one of said at least two amplifying transistors (T1, T2) to at least one processing means with photosensitive material is used to control the gate (G) or the base of said at least one of said at least two amplifying transistors (T1, T2).
